# EUROPÄISCHE PATENTANMELDUNG

(11) **EP 1 345 329 A2**
(43) Veröffentlichungstag der Anmeldung: **17.09.2003**
(21) Anmeldenummer: 03004529.8
(22) Anmeldetag: 28.02.2003
(51) Int. Cl.: H03M 1/06, H03M 3/04

(54) **Geregelte Ansteuerschaltung für einen analog angesteuerten Leistungshalbleiter**

(30) Priorität: 13.03.2002 DE 10211075
(71) Anmelder: SIEMENS AKTIENGESELLSCHAFT, 80333 München (DE)
(72) Erfinder: Bruckmann, Manfred, 90475 Nümberg (DE); Köpken, Hans-Georg, Dr., 91056 Erlangen (DE); Wald, Alois, 91325 Adelsdorf (DE); Weis, Benno, 91334 Hemhofen (DE)

(57) **Zusammenfassung**

Die Erfindung betrifft eine Geregelte Ansteuerschaltung für einen analog angesteuerten Leistungshalbleiter.

Hierzu ist ein digital arbeitender Logikbaustein (2) vorgesehen, der mit einem Steuereingang (7) versehen ist, an den über einen A/D-Wandler (6) Steuersignale zuführbar sind, mit denen das digitale Ausgangssignal des Logikbausteins (2) beeinflussbar ist, das auf einen Baustein oder eine Baugruppe zur Wandlung dieses Ausgangssignals in eine analoge oder quasi-analoge Steuergröße für den Leistungshalbleiter (3) geschaltet ist.

## Beschreibung

Geregelte Ansteuerschaltung für einen analog angesteuerten Leistungshalbleiter

Die Erfindung betrifft eine geregelte Ansteuerschaltung für einen analog angesteuerten Leistungshalbleiter.

Leistungshalbleiter benötigen zu ihrem Betrieb eine Ansteuerschaltung, die am Steuereingang des Leistungshalbleiters eine Spannung beziehungsweise einen Strom zur Verfügung stellt. Aus verschiedenen Gründen ist es vorteilhaft, den Steuereingang des Leistungshalbleiters mit einer analog steuerbaren Spannung oder einem spannungsgesteuerten Strom zu beaufschlagen, das heißt eine Steuergröße anzubieten, die einen beliebigen Wert innerhalb der Höhe der Versorgungsspannung annehmen kann. Die Steuergröße kann von verschiedenen Zustandsdaten des Leistungshalbleiters abhängig gemacht werden, so zum Beispiel der Kollektor-Emitter-Spannung, dem Kollektorstrom oder der Temperatur des Leistungshalbleiters. Ein oder mehrere der Zustandsdaten werden auf die Ansteuerschaltung zurückgekoppelt, die dann die Steuergröße entsprechend ausregelt.

Üblicherweise weist die Ansteuerschaltung die folgende Architektur auf:

Über eine Potentialschnittstelle wird ein Steuersignal, das zum Beispiel von einem Microcontroller kommt, an den Eingang einer Ansteuerlogik übertragen. Der Ausgang des Logikbausteins ist mit einem Baustein zur Signalformung und Signalverstärkung verbunden, in dem das Steuersignal so aufbereitet wird, dass es den Leistungshalbleiter in der gewünschten Weise anzusteuern vermag.

Die Rückführung für die Zustandsdaten des Leistungshalbleiters kann nun auf die Ansteuerlogik und auf den Baustein zur Signalformung und -verstärkung erfolgen und diese beeinflussen. Während die Rückführung auf den Logikbaustein nur ein Ausschalten des Leistungshalbleiters bewirken kann, zum Beispiel um einen unzulässigen Betriebszustand zu verhindern, sowie ein Wiedereinschalten nach Wegfall des eine Einschaltung verbietenden Ereignisses, wirkt die Rückführung auf den analogen Baustein zur Signalformung und -verstärkung in der Weise, dass das Steuersignal am Eingang des Leistungshalbleiters so analog verstellt wird, dass den gemessenen Zustandsdaten entgegengewirkt werden kann. Ein solcher Aufbau der Ansteuerschaltung hat den Nachteil, dass der Baustein zur Signalformung und -verstärkung nur eine bestimmte Kurvenform am Eingang des Leistungshalbleiters zu erzeugen vermag und deshalb immer nur für einen bestimmten Leistungshalbleiter geeignet ist. Soll zum Beispiel ein anderer Leistungshalbleiter-Typ oder eine andere Leistungshalbleiter-Generation verwendet werden, so muss der gesamte analoge Schaltungsteil überarbeitet werden. Außerdem muss auch die Rückführung an den analogen Schaltungsteil beziehungsweise der Eingang des analogen Schaltungsteils für die Rückführung an diesen angepasst sein. Dies schränkt den Entwicklungsfreiraum ein und ist in der Realisierung sehr aufwendig.

Der Erfindung liegt die Aufgabe zugrunde, eine Ansteuerschaltung anzugeben, die einfacher aufgebaut und universell einsetzbar ist.

Erfindungsgemäß wird die Aufgabe gelöst durch die Merkmale des Anspruchs 1. Zweckmäßige Ausgestaltungen sind Gegenstand der Unteransprüche.

Danach weist die Ansteuerschaltung einen digital arbeitenden Logikbaustein auf, der mit einem Steuereingang versehen ist, an den über einen A/D-Wandler Steuersignale zuführbar sind, mit denen das digitale Ausgangssignal des Logikbausteins beeinflussbar ist. Dieses Ausgangssignal ist auf einen Baustein oder eine Baugruppe zur Wandlung in eine analoge oder quasi-analoge Steuergröße für den Leistungshalbleiter geschaltet.

Durch Beeinflussung des Logikbausteins mit einem digital gewandelten Rückführungssignal wird im Logikbaustein eine Steuergröße für die Steuerspannung des Leistungshalbleiters gebildet. Diese Steuergröße beliebiger Bitbreite (größer als 1 Bit) wird einem Baustein beziehungsweise einer Baugruppe zugeführt, die die Wandlung des im Logikbaustein erzeugten digitalen Steuersignals in eine analoge oder quasi-analoge Steuergröße für den Leistungshalbleiter übernimmt. Diese Baugruppe zur Wandlung des Steuersignals kann zum Beispiel ein D/A-Wandler mit nachgeschaltetem Verstärker sein. Zustandsrückmeldungen, welche die Steuergröße des Leistungshalbleiters analog beeinflussen sollen, müssen nun nicht mehr auf den analogen Schaltungsteil der Ansteuerschaltung wirken. Sie werden über einen A/D-Wandler mit beliebiger Bitbreite (größer als 1 Bit) an den Logikbaustein übermittelt, in welchem dann Korrektur und Formung der Steuergröße erfolgen.

Der analoge Wert des D/A-Wandlers wird zweckmäßig über einen breitbandigen, leistungsfähigen Verstärker an den Steuereingang des Leistungshalbleiters übertragen.

Für den Logikbaustein kann eine diskrete Logikschaltung oder ein programmierbarer Logikbaustein (flüchtig oder nichtflüchtig) eingesetzt werden.

Für die D/A-Wandlung kann ein herkömmlicher, zur D/A-Wandlung geeigneter IC (DAC-IC) oder eine herkömmliche diskrete Schaltung eingesetzt werden.

Für die Verstärkung kann ein breitbandiger Operationsverstärker benutzt werden. Alternativ dazu kann auch eine übliche diskrete Schaltung eingesetzt werden, die eine spannungsgesteuerte Stromquelle oder einen Spannungsumsetzer realisiert. Falls der D/A-Wandler eine ausreichende Ausgangsleistung hat, kann gegebenenfalls auf einen Verstärker ganz verzichtet werden.

Für die A/D-Wandlung kommt in gleicher Weise ein herkömmlicher, zur A/D-Wandlung geeigneter IC (ADC-IC) in Frage. A1-ternativ dazu kann eine diskrete Schaltung zur Wandlung des Analogwertes in ein digitales Signal mit einer Bitbreite von mehr als 1 Bit eingesetzt werden. Für jede einzelne Zustandsrückmeldung kann dabei eine eigene Schaltung zur A/D-Wandlung oder auch ein A/D-Wandler für mehr als eine Zustandsrückmeldung verwendet werden, indem die Zustandsrückmeldungen zeitlich nacheinander (zeitmultiplex) an den Eingang des A/D-Wandlers angelegt werden.

Der Logikbaustein kann in einen speziell angepassten IC (ASIC) integriert werden. Zusätzlich können in den ASIC dann auch die D/A-Wandlung und die A/D-Wandlung, gegebenenfalls auch die Verstärkung, integriert werden. Im Logikbaustein kann gleichzeitig ein Regelalgorithmus für das Leistungsstellglied des Leistungshalbleiters hinterlegt sein, wobei für den Logikbaustein dann ein Mikroprozessor Verwendung finden kann.

Die Baugruppe zur Wandlung des im Logikbaustein erzeugten digitalen Steuersignals in eine analoge oder quasi-analoge Steuergröße für den Leistungshalbleiter kann neben der D/A-Wandlung mit anschließender Verstärkung auch mit anderen Verfahren realisiert werden. Beispielsweise kann der D/A-Wandler einen Wert ausgeben, der als Sollwert für einen analogen Regelkreis mit dem Verstärker dient. Dieser analoge Regelkreis realisiert dann die Spannung am Gate des Leistungshalbleiters. Die Regelung kann auch digital über den Logikbaustein erfolgen. In diesem Fall entfiele der D/A-Wandler. Stattdessen wird die Gatespannung gemessen und über einen A/D-Wandler an den Logikbaustein übermittelt. Dieser gibt dann an den Verstärker das Signal, die Gatespannung zu erhöhen oder zu erniedrigen.

Das Steuersignal für den Leistungshalbleiter kann auch quasianalog bereitgestellt werden, indem sie aus einem digitalen Signal geeigneter Spannung gewonnen wird. Das digitale Signal kann zum Beispiel durch einen Sigma-Delta-Modulator, durch Pulsbreitenmodulation oder durch einen digitalen Regler bereitgestellt werden. Diese Spannung wird anschließend durch einen Tiefpassfilter geleitet. Der Tiefpassfilter besteht im einfachsten Fall aus einem Vorwiderstand und der Gatekapazität. Filter höherer Ordnung, zum Beispiel mit Widerständen, Kondensatoren und Spulen, sind ebenfalls möglich.

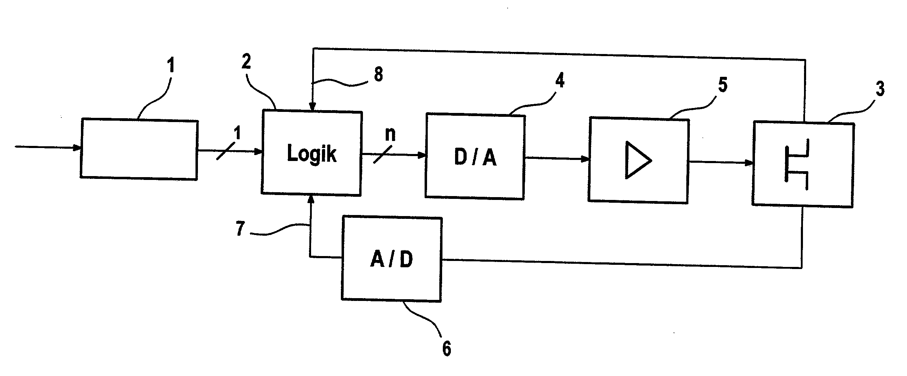

Die Erfindung wird nachfolgend unter Bezugnahme auf die Zeichnung beispielhaft näher erläutert. Die Zeichnung zeigt ein Prinzipschaltbild der erfindungsgemäßen Architektur einer Ansteuerschaltung.

Ein Steuersignal wird über eine Potentialschnittstelle 1 an einen digitalen Logikbaustein 2 übertragen, der auch die digitale Signalformung der Steuergröße für die Ansteuerung eines Leistungshalbleiters 3 übernimmt. Dem Logikbaustein 2 sind ein D/A-Wandler 4 und ein Verstärker 5 nachgeschaltet. Der Verstärker 5 ist mit dem Gate des Leistungshalbleiters 3 verbunden. Vom Leistungshalbleiter 3 werden Zustandsdaten über einen A/D-Wandler 6 an einen Eingang 7 des Logikbausteins 2 zurückgeführt. Außerdem können gegebenenfalls in bisher bekannter Weise zusätzlich Zustandsrückmeldungen direkt digital an einen weiteren Eingang 8 des Logikbausteins 2 erfolgen, mit denen beispielsweise die Ansteuerung des Leistungshalbleiters 3 unverzögert gesperrt werden kann.

Mit den Zustandsdaten des Leistungshalbleiters 3, die über den A/D-Wandler 6 an den Logikbaustein 2 zurückgeführt werden, wird dort digital ein Wert für die Steuerspannung am Gate des Leistungshalbleiters 3 gebildet, der nach D/A-Wandlung im D/A-Wandler 4 und Verstärkung im Verstärker 5 am Gate des Leitungshalbleiters 3 wirkt.

## Patentansprüche

1. Geregelte Ansteuerschaltung für einen analog angesteuerten Leistungshalbleiter (3) mit einem digital arbeitenden Logikbaustein (2), der mit einem Steuereingang (7) versehen ist, an den über einen A/D-Wandler (6) Steuersignale zuführbar sind, mit denen das digitale Ausgangssignal des Logikbausteins (2) beeinflussbar ist, das auf einen Baustein oder eine Baugruppe zur Wandlung dieses Ausgangssignals in eine analoge oder quasi-analoge Steuergröße für den Leistungshalbleiter (3) geschaltet ist.

2. Ansteuerschaltung nach Anspruch 1, **dadurch gekennzeichnet,dass** die Baugruppe zur Wandlung des Ausgangssignals des Logikbausteins (2) in eine analoge oder quasi-analoge Steuergröße für den Leistungshalbleiter (3) ein D/A-Wandler (4) mit nachgeschaltetem Verstärker (5) ist.

3. Ansteuerschaltung nach Anspruch 2, **dadurch ge-kennzeichnet,dass** der Verstärker (5) ein Operationsverstärker ist.

4. Ansteuerschaltung nach Anspruch 2 oder 3, **dadurch gekennzeichnet, dass** der Verstärker (5) geregelt ist.

5. Ansteuerschaltung nach Anspruch 2, **dadurch gekennzeichnet,dass** dem D/A-Wandler (4) eine spannungsgesteuerte Stromquelle nachgeschaltet ist.

6. Ansteuerschaltung nach Anspruch 2, **dadurch gekennzeichnet, dass** der D/A-Wandler (4) als Regler für die Steuergröße des Leistungshalbleiters (3) ausgebildet ist.

7. Ansteuerschaltung nach einem der vorhergehenden Ansprüche, **dadurch gekennzeichnet, dass** der Logikbaustein (2) ein integrierter Schaltkreis ist.

8. Ansteuerschaltung nach Anspruch 7, **dadurch gekennzeichnet,dass** in den integrierten Schaltkreis ein D/A-Wandler und/oder ein Verstärker und/oder ein A/D-Wandler integriert sind.

9. Ansteuerschaltung nach einem der Ansprüche 1 bis 6, **dadurch gekennzeichnet, dass** der Logikbaustein (2) ein Mikroprozessor ist.

10. Ansteuerschaltung nach einem der vorhergehenden Ansprüche, **dadurch gekennzeichnet, dass** in dem Logikbaustein (2) ein Regelalgorithmus für das Stellglied des Leistungshalbleiters (3) hinterlegt ist.
